# FASCICULE DE BREVET EUROPEEN

(11) **EP 3 792 957 B1**
(45) Date de publication et mention de la délivrance du brevet: **06.11.2024**
(21) Numéro de dépôt: 20195063.1
(22) Date de dépôt: 08.09.2020
(51) Int. Cl.: H01L 21/20

(54) **PROCÉDÉ DE FABRICATION D'UN SUBSTRAT MIXTE**
VERFAHREN ZUR HERSTELLUNG EINES MISCHSUBSTRATS
METHOD FOR MANUFACTURING A MIXED SUBSTRATE

(30) Priorité: 11.09.2019 FR 1910002
(43) Date de publication de la demande: 17.03.2021
(73) Titulaire: Commissariat à l'Energie Atomique et aux Energies Alternatives, 75015 Paris (FR)
(72) Inventeur: NIEBOJEWSKI, Heimanu, 38054 GRENOBLE CEDEX 09 (FR)
(74) Mandataire: Brevalex

(56) Documents cités:
- WO-A1-2019/094052
- US-A1- 2014 264 636

## Description

### DOMAINE TECHNIQUE

La présente invention se rapporte au domaine de la microélectronique, et notamment celui des substrats pour la microélectronique.

La présente invention concerne en particulier un procédé de fabrication d'un substrat mixte ou hybride permettant la co-intégration de régions ou d'empilements de nature différente.

La présente invention concerne, selon un mode de réalisation particulier, un procédé de fabrication d'un substrat mixte pourvu de régions dites SOI (Silicium sur Isolant) reposant sur une couche de piégeage (« SOI Trap Rich » selon la terminologie Anglo-Saxonne) et de régions faites d'un matériau monobloc ou massif (« Bulk » selon la terminologie Anglo-Saxonne).

La présente invention concerne notamment un procédé de fabrication d'un substrat mixte permettant la co-intégration de structures logiques, analogiques, et radio fréquence.

### ÉTAT DE LA TECHNIQUE ANTÉRIEURE

L'intérêt pour les substrats mixtes ou hybrides n'est aujourd'hui plus à démontrer.

En effet, ces derniers généralement pourvus de zones dites massives (« bulk » selon la terminologie Anglo-Saxonne), et de zones du type « SOI » permettent de réaliser des composants de nature différente sur un seul et même substrat.

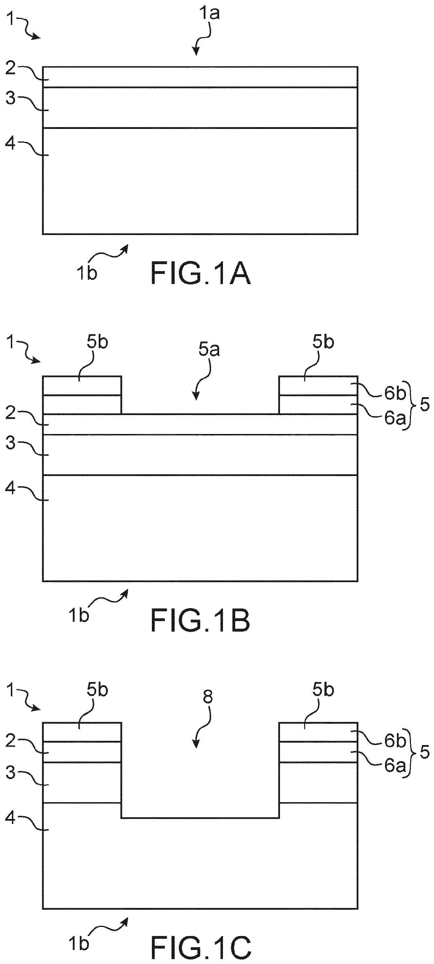

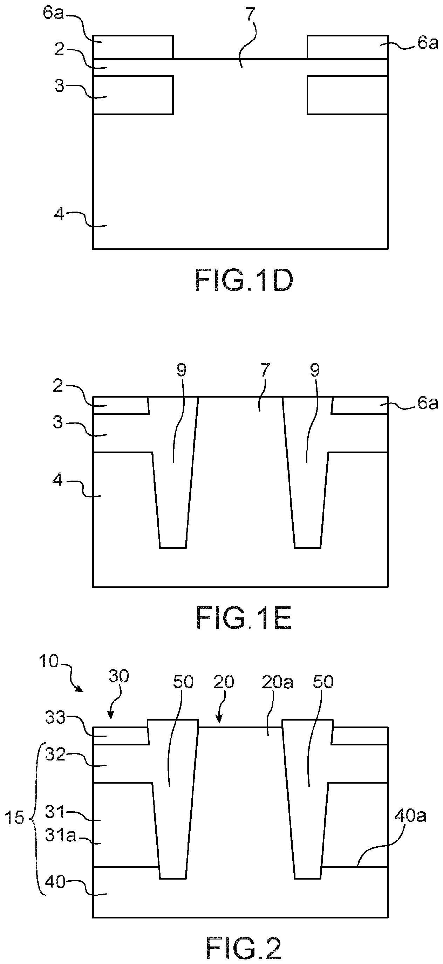

À cet égard, un procédé de formation d'un substrat mixte (ou hybride) connu de l'état de la technique est illustré aux figures 1A à 1E.

Ce procédé comprend notamment les étapes suivantes consistant à :
i) fournir un substrat SOI 1 qui comprend un empilement comprenant de sa face avant 1A vers sa face arrière 1b une couche utile 2, faite de silicium, une couche diélectrique 3, faite de dioxyde de silicium, et un substrat support 4 fait de silicium monocristallin ;
ii) former un masque 5 pourvu d'ouvertures 5a exposant des premières régions de l'empilement, et destiné à protéger des deuxièmes régions de l'empilement à l'aide de parties 5b ;
iii) former des cavités 8 par gravure complète de la couche utile 2 et la couche diélectrique 3 au niveau des ouvertures 5a ;
iv) remplir les cavités 8 de silicium monocristallin 7 par croissance épitaxiale.

La formation du masque lors de l'exécution de l'étape ii) peut impliquer la formation d'une couche d'un matériau diélectrique 6a en recouvrement de la face avant, et la définition des ouvertures 5a au moyen d'un masque de résine 6b réalisé selon un procédé photo lithographique.

À l'issue de l'étape de iv), les premières régions du substrat mixte sont faites de silicium massif, tandis que les deuxièmes régions comprennent un empilement SOI.

L'étape iv) peut également être suivie d'une étape v) de formation de tranchées d'isolation de surface 9 (« STI » ou « Shallow Trench Isolation » selon la terminologie Anglo-Saxonne), destinées à isoler les premières régions des deuxièmes régions.

Ce procédé connu de la technique et exécuté sur un substrat SOI limité à une couche utile et une couche diélectrique est relativement satisfaisant.

Toutefois, dès lors que les applications envisagées impliquent la formation de composants radio fréquence, une couche de piégeage (« Trap Rich » selon la terminologie Anglo-Saxonne) est intercalée entre la couche diélectrique et le substrat support.

Cette couche de piégeage comprend notamment du silicium poly cristallin susceptible de perturber l'exécution de l'étape iv). En particulier, la couche de piégeage exposée au niveau des parois des cavités perturbe l'exécution de l'étape iv), et est, par voie de conséquence, à l'origine d'une croissance erratique et de la création de défauts.

Un but de la présente invention est donc de proposer un procédé de fabrication d'un substrat mixte permettant de limiter le nombre de défauts lors de l'exécution de l'étape de croissance épitaxiale.

Un autre but de la présente invention est de proposer un procédé de fabrication d'un substrat mixte pourvu de premières régions massives et de deuxièmes région comprenant un empilement du type SOI reposant sur une couche de piégeage.

Les documents WO 2019/094052 et US 2014/264636 décrivent des procédés de fabrication similaires.

### EXPOSÉ DE L'INVENTION

La présente invention propose donc un procédé de fabrication d'un substrat mixte à partir d'un substrat de départ.

Le substrat de départ comprend, d'une face avant vers une face arrière, une couche intermédiaire reposant sur un substrat support, notamment un substrat de silicium monocristallin.

La couche intermédiaire, selon les termes de la présente invention, comprend un matériau susceptible de servir de germe à une croissance par épitaxie d'un premier matériau.

Par « servir de germe », on entend une couche au niveau de laquelle des germes de croissance dudit premier matériau peuvent être observés au cours d'une étape de croissance épitaxiale. À titre d'exemple, la couche intermédiaire peut comprendre un matériau poly cristallin, et plus particulièrement du silicium poly cristallin.

L'invention comprend donc la formation d'une cavité dans le substrat de départ à partir de la face avant et qui s'étend jusque dans le substrat support. Les parois de la cavité sont ensuite tapissés d'une couche de protection, faite d'un matériau amorphe de manière à masquer les sections de la couche intermédiaire découvertes au niveau desdits parois.

Enfin, le premier matériau est déposé par épitaxie à partir du fond de la cavité afin de former une première région.

Le substrat support est, à cet égard, configuré pour favoriser une croissance monocristalline du premier matériau.

La mise en oeuvre de la couche de protection permet d'exercer un meilleur contrôle de la croissance du premier matériau, et en particulier de limiter la création de défauts par une germination du premier matériau au niveau des parois de la cavité.

Les buts de la présente invention sont donc, au moins en partie, atteints par un procédé de fabrication d'un substrat mixte qui comprend, sur une face principale d'un substrat support, une première région, comprenant un premier matériau monocristallin, et une seconde région, contiguë à la première région, et comprenant un deuxième matériau, le procédé comprend les étapes suivantes :
a) fournir un substrat de départ qui comprend une l'empilement, formé d'au moins une couche intermédiaire, et en recouvrement de la face principale du substrat support, la couche intermédiaire comprenant le deuxième matériau sous forme monocristalline ou polycristalline ;
b) former un masque sur la l'empilement, ledit masque comprenant une ouverture délimitant l'emplacement de la première région ;
c) graver l'empilement au niveau de l'ouverture de manière à former une cavité délimitée par un fond et des parois, le fond étant situé sur ou dans le substrat support ;
d) former l'au moins une première région par croissance épitaxiale du premier matériau sous forme monocristalline dans l'au moins une cavité,
le procédé étant caractérisé en ce qu'il comprend une étape c1), exécutée avant l'étape d), de formation d'une couche de protection, faite d'un matériau amorphe, en recouvrement des parois de l'au moins une cavité et laisse exposée à l'environnement extérieur le fond de ladite cavité.

Selon un mode de réalisation avantageux, l'étape d) comprend également une gravure du premier matériau susceptible d'être formé sous forme polycristalline sur les parois de l'au moins une cavité.

Selon un mode de réalisation avantageux, l'étape c1) comprend la formation d'une couche de matériau en recouvrement l'empilement, du fond et des parois des cavités, l'étape c1) comprenant en outre le retrait de ladite couche de matériau au niveau du fond des cavités.

Le retrait de la couche de matériau peut comprendre une gravure sèche anisotrope.

Selon un mode de mise en oeuvre, la couche de protection comprend au moins des matériaux choisi parmi : dioxyde de silicium, nitrure de silicium, SiCO, SiBCN.

Selon un mode de mise en oeuvre, l'étape d) comprend au moins une séquence comprenant les étapes :
d1) faire croître de manière épitaxiale une couche faite du premier matériau en recouvrement du fond et des parois de l'au moins une cavité ;
d2) graver sélectivement la couche faite du premier matériau déposée sur les parois de l'au moins une cavité ;
la séquence est alors répétée autant de fois que nécessaire pour que l'au moins une cavité soit remplie avec le premier matériau monocristallin.

Cette au moins une séquence est avantageusement mise en oeuvre lorsque l'au moins une cavité présente un rapport d'aspect supérieur à un quart.

Selon un autre mode de mise en oeuvre, l'étape d) comprend une étape de croissance épitaxiale permettant de faire croître le premier matériau de manière monocristalline à partir du fond de la cavité, et de manière polycristalline sur la couche de protection, l'étape de croissance étant exécutée en présence d'un agent chimique permettant de graver sélectivement le premier matériau sous forme polycristalline au regard de sa forme monocristalline.

Par exemple, l'étape d) met en oeuvre un précurseur comprenant du SiH₄ ou du dichlorosilane (DCS), et un agent chimique comprenant du HCl.

Ce mode de mise en oeuvre permet avantageusement de considérer des cavités présentant un rapport d'aspect petit et notamment inférieur à un quart.

Selon un mode de mise en oeuvre, l'au moins une première région et l'au moins une deuxième région présentent chacune une surface exposée à l'environnement extérieur en affleurement l'une de l'autre.

Avantageusement, l'empilement peut comprendre en outre une couche utile et une couche diélectrique disposée entre ladite couche utile et la couche intermédiaire, le couche utile et la couche diélectrique étant également gravées au niveau de l'au moins une ouverture lors de l'exécution de l'étape c).

Par exemple, la couche utile peut comprendre du silicium, la couche diélectrique peut comprendre du dioxyde de silicium, et la couche intermédiaire peut comprendre du silicium polycristallin.

Selon un mode de mise en oeuvre, l'étape b) comprend la formation d'un masque dur, le masque dur comprend notamment un matériau diélectrique.

Selon un mode de mise en oeuvre, l'étape c) comprend une gravure sèche, notamment une gravure plasma.

Selon un mode de mise en oeuvre, le procédé comprend en outre une étape e), exécutée après l'étape d), de formation d'une tranchée d'isolation remplie d'un matériau diélectrique destinées isoler électriquement l'au moins une première région de l'au moins une deuxième région.

Selon un mode de mise en oeuvre, la tranchée d'isolation s'étend jusque dans le substrat support ou s'arrête dans la couche intermédiaire.

### BRÈVE DESCRIPTION DES DESSINS

D'autres caractéristiques et avantages apparaîtront dans la description qui va suivre d'un procédé de fabrication d'un substrat mixte, donnés à titre d'exemples non limitatifs, en référence aux dessins annexés dans lesquels :
Les figures 1A, 1B, 1C, 1D, 1E sont des représentations schématiques des différentes étapes mises en oeuvre pour la réalisation d'un substrat mixte connu de l'état de la technique, ces figures sont notamment des vues selon un plan de coupe perpendiculaire à la face avant du substrat SOI ;
La figure 2 est une représentation schématique d'un substrat mixte susceptible d'être obtenu par le procédé de fabrication selon la présente invention, cette figure est représentée selon un plan de coupe perpendiculaire à une face principale du substrat support ;
Les figures 3A, 3B, 3C, 3D, 3E sont des représentations schématiques des différentes étapes mises en oeuvre pour la réalisation d'un substrat mixte connu selon la présente invention, ces figures sont notamment des vues selon un plan de coupe perpendiculaire à une face principale du substrat support ;
Les figures 4A, 4B, 4C sont des représentations schématiques illustrant la formation de la couche de protection par oxydation thermique ;
Les figures 5A, 5B illustrent de manière schématique la formation de tranchées d'isolation selon la première variante de la présente invention ;
Les figures 6A, 6B illustrent de manière schématique la formation de tranchées d'isolation selon la seconde variante de la présente invention ;
La figure 7 est une représentation schématique d'un substrat mixte obtenu par le procédé de fabrication selon la présente invention et sur lequel sont formés des dispositifs microélectroniques.

### EXPOSÉ DÉTAILLÉ DE MODES DE RÉALISATION PARTICULIERS

La présente invention concerne un procédé de fabrication d'un substrat mixte (ou hybride) à partir d'un substrat de départ.

Tel que représenté à la figure 2, le substrat mixte 10 comprend une ou plusieurs premières régions 20, une ou plusieurs deuxièmes régions 30, et un substrat support 40. Notamment, l'une ou plusieurs premières régions 20 ainsi que l'une ou plusieurs deuxièmes régions 30 reposant sur une face principale 40a du substrat support 40.

La première région 20 comprend un premier matériau 20a monocristallin et dont l'orientation cristallographique est imposée par l'orientation cristallographique du substrat support 40. Il ressortira de manière évidente dans la suite de la description que le substrat support 40, dès lors qu'il impose l'orientation cristalline du premier matériau 20a, est également sous forme monocristalline. Le premier matériau peut comprendre du Si ou du SiGe.

La deuxième région 30 comprend au moins une couche intermédiaire 31 faite d'un second matériau 31a.

La couche intermédiaire 31 est destinée à assurer une fonction de piégeage, et plus particulièrement une fonction de piégeage de charges résultant par exemple de la résistivité électrique du second matériau 31a.

Cet effet de piégeage des charges permet de limiter les diaphonies (« CrossTalk » selon la terminologie Anglo-Saxonne) entre des dispositifs microélectroniques adjacents.

Le second matériau 31a peut, à cet égard, comprendre un matériau polycristallin, et plus particulièrement du silicium polycristallin.

Selon un mode de réalisation particulièrement avantageux, la deuxième région 30 peut également comprendre, reposant sur le second matériau et dans l'ordre, une couche diélectrique 32 et une couche utile 33.

Par « couche utile », on entend une couche sur ou dans laquelle un ou plusieurs dispositifs, par exemple microélectronique(s), est ou sont destiné(s) à être formé(s). La couche utile peut notamment comprendre une région destinée à former un canal de transistor.

Le substrat mixte comprend également des espaceurs 50 isolant électriquement les premières régions 20 des deuxièmes régions 30.

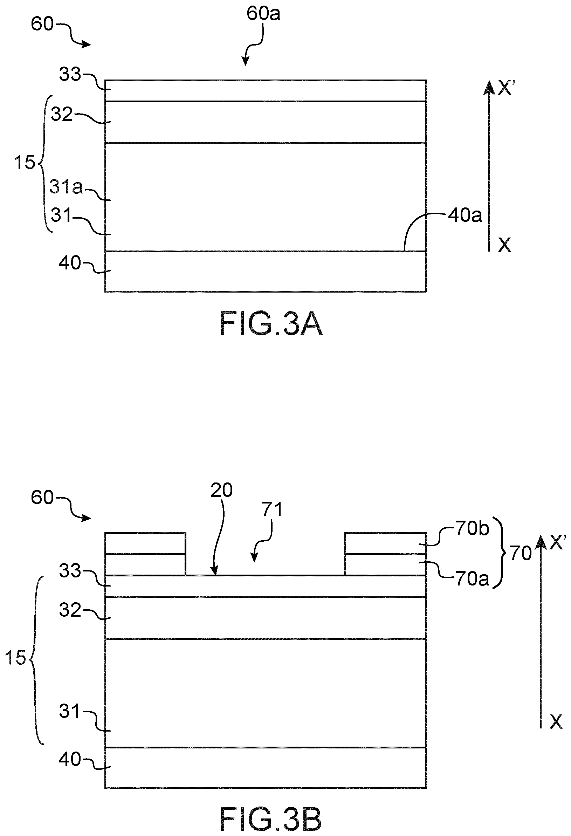

Le procédé de fabrication du substrat mixte est décrit, dans la suite de l'énoncé, en relation avec les figures 3A à 3E.

Le procédé comprend une étape a) qui consiste à fournir un substrat de départ 60.

Le substrat de départ 60 est formé par un empilement 15 de couches, comprenant notamment une couche intermédiaire 31 qui repose sur la face principale 40a du substrat support 40 (figure 3A).

« Un empilement », selon les termes de la présente invention comprend une couche ou un empilement de couches. On définit alors une direction d'empilement suivant un axe orthogonal à la face principale 40a du substrat support 40 et le traversant. On définit également un sens d'empilement suivant la direction d'empilement XX' s'étendant depuis la face principale 40a du support 40 vers la dernière couche empilée.

Selon un mode de réalisation avantageux, l'empilement 15 peut comprendre, selon le sens d'empilement la couche intermédiaire 31, une couche diélectrique 32, et une couche utile 33.

La description détaillée du procédé de fabrication d'un substrat mixte selon la présente invention est limitée à la mise en oeuvre d'un substrat de départ 60 pourvu du substrat support 40 et sur une face principale 40a duquel reposent, et dans l'ordre (en d'autres termes, selon le sens d'empilement XX'), la couche intermédiaire 31, la couche diélectrique 32 et la couche utile 33.

L'homme du métier avec ses connaissances générales et la description qui suit, pourra sans difficulté adapter l'invention à un substrat de départ dépourvu de l'une et/ou de l'autre de la couche diélectrique 32 et de la couche utile 33.

Selon un mode de réalisation particulièrement avantageux, le substrat de départ 60 est un substrat de silicium sur isolant intégrant une couche intermédiaire dite de piégeage (« SOI trap Rich » selon la terminologie Anglo-Saxonne).

À titre d'exemple, la couche intermédiaire 31 est faite du second matériau 31a en silicium polycristallin (« Poly Silicium ») d'une épaisseur comprise entre 10 nm et 2000 nm, la couche diélectrique 32 peut comprendre du dioxyde de silicium et présenter une épaisseur comprise entre 10 nm et 145 nm (par exemple égale à 25 nm), et la couche utile 33 peut comprendre du silicium et présenter une épaisseur comprise entre 3 nm et 30 nm (par exemple égale à 6 nm).

Le procédé selon la présente invention comprend une étape b) de formation d'un masque 70 sur la dernière couche de l'empilement 15 (figure 3B).

Le masque 70 comprend notamment une ou plusieurs ouvertures 71 délimitant l'emplacement de la première région 20.

Le masque 70 peut comprendre un masque dur (« Hard Mask » selon la terminologie Anglo-Saxonne).

La formation du masque dur peut impliquer la séquence suivante :
- le dépôt d'une ou plusieurs couches de masquage 70a, par exemple une couche de nitrure de silicium et/ou de dioxyde de silicium ;
- le dépôt d'une couche de résine photolithographique 70b en recouvrement de l'une ou plusieurs couches de masquage 70a ;
- une étape de photolithographie destinée à imprimer le motif relatif à l'ouverture 71 ;

- une étape de gravure de l'une ou plusieurs couches de masquage 70a au travers du motif afin de former l'ouverture 71.

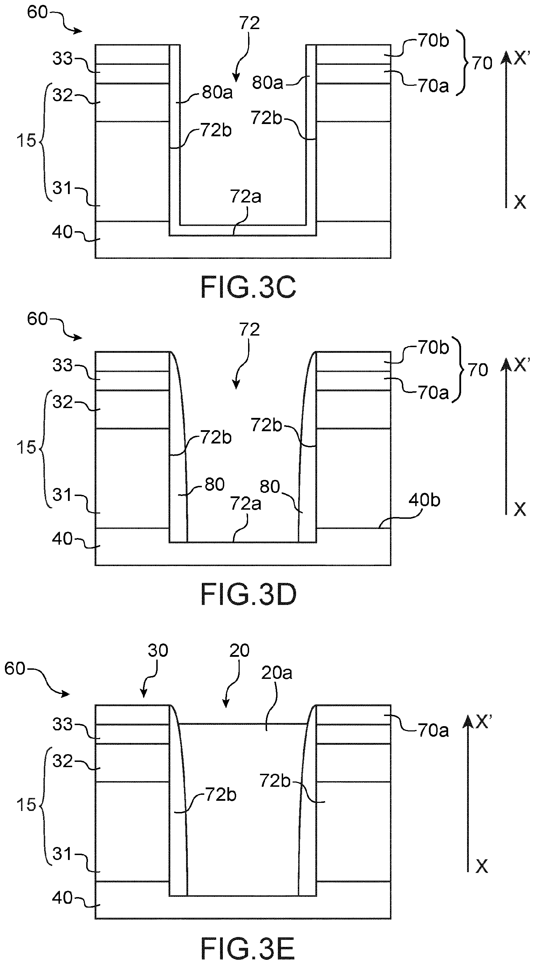

L'étape b) est suivie d'une étape c) qui consiste à graver la couche utile 33, la couche diélectrique 32 et la couche intermédiaire 31 au niveau de l'ouverture 71 de manière à former une cavité 72 dans le substrat de départ 60 (figure 3C).

La cavité 72 est délimitée par un fond 72a surmonté de parois 72b qui s'étendent depuis la couche utile 33 vers au moins l'interface 40b entre la couche intermédiaire 31 et le substrat support 40. En d'autres termes, le substrat support 40 présente une section exposée formant le fond 72a de la cavité 72.

Selon une première variante, l'étape de gravure c) peut être arrêtée au niveau de l'interface 40b formée entre la couche intermédiaire 31 et le substrat support 40, ou selon une seconde variante être arrêtée dans le volume du substrat support 40. Il est entendu que la mise en oeuvre de la seconde variante permet de conserver une partie indemne du substrat support 40 de manière à former le fond 72a de la cavité 72.

L'étape de gravure c) peut comprendre une gravure sèche, et notamment une gravure plasma. Par exemple, l'étape de gravure sèche peut être exécutée au moyen d'un plasma fluorocarboné dans un équipement de gravure ionique réactive (« RIE » ou « Reactive Ion Etching » selon la terminologie Anglo-Saxonne).

Le procédé selon la présente invention comprend également une étape c1) de formation d'une couche de protection 80. Selon un exemple de réalisation la couche de protection 80 est faite d'un matériau amorphe. Comme l'illustre la figure 3D, à l'issue de l'étape c1), la couche de protection 80 est située sur les parois 72b délimitant la cavité 72 (figure 3D).

Plus particulièrement, la couche de protection 80 est formée en recouvrement des parois 72b et laisse exposée à l'environnement extérieur le fond 72a de la cavité 72. Plus particulièrement, et de manière avantageuse, la couche de protection 80, à l'issue de l'étape c1), recouvre exclusivement, et avantageusement entièrement, les parois 72b de la cavité, et laisse la fond 72a exposé à l'environnement extérieur.

L'étape c1) peut notamment comprendre la formation d'une couche de matériau 80a, notamment un matériau diélectrique, en recouvrement du fond 72a et des parois 72b de la cavité 72, suivie du retrait de ladite couche de matériau 80a au niveau du fond de la cavité 72 (figure 3C et 3D).

Selon une alternative, la formation de la couche de matériau 80a peut comprendre une étape de dépôt d'un matériau isolant électriquement, tel qu'un diélectrique. Par exemple, le dépôt peut être exécuté par une technique de dépôt par couches atomiques (« ALD » ou « Atomic Layer Déposition » selon la terminologie Anglo-Saxonne) qui permet un dépôt conforme. La couche de matériau 80a peut à cet égard comprendre l'un des matériaux choisi parmi : Si₃N₄, SiO₂, SiCO.

L'épaisseur de la couche de protection 80 post-dépôt peut être comprise entre 5 nm et 15 nm.

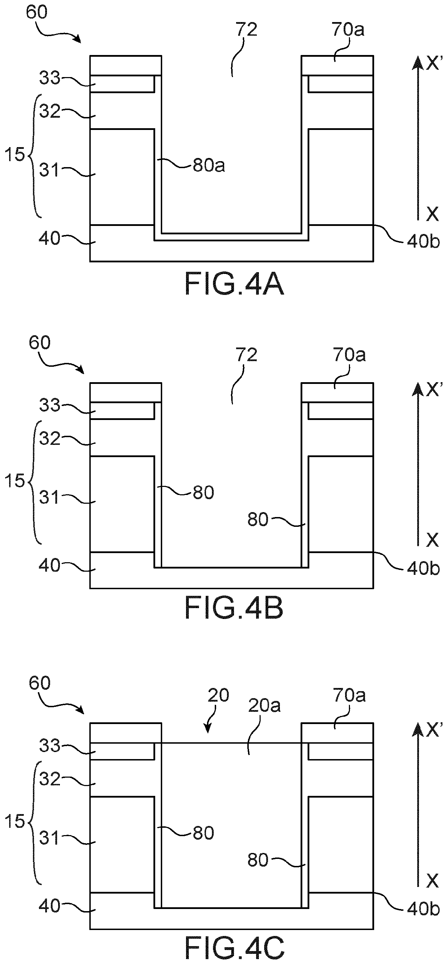

Les figures 4A et 4B sont des représentations schématiques d'une autre alternative de mise en oeuvre de l'étape c1). Plus particulièrement, la figure 4A illustre de manière schématique la formation de la couche de matériau 80a, tandis que la figure 4B est relative à une étape de retrait discutée ci-après. Selon cette autre alternative, la formation de la couche de matériau 80a peut être formée par oxydation thermique (figure 4A). Dès lors que le substrat de départ 60 comprend une couche intermédiaire faite de silicium, et plus particulièrement de polysilicium, la couche de matériau 80a comprend du dioxyde de silicium.

Quelle que soit l'alternative considérée pour la formation de la couche de protection 80, le retrait de la couche de matériau 80a au niveau du fond de la cavité 72 peut être exécuté, tel qu'illustré aux figures 3D et 4B, par une étape de gravure anisotrope. Cette gravure anisotrope est connue de l'homme du métier et est semblable à celle mise en oeuvre pour la formation d'espaceurs sur les faces latérales d'une grille de transistor.

L'étape c1) de formation de la couche de protection 80 est suivie d'une étape d) de formation de la première région 20 par croissance épitaxiale et sélective du premier matériau 20a sous forme monocristalline dans la cavité 72 (figure 3E). L'étape d) peut notamment être exécutée pour que le premier matériau 20a remplisse intégralement la cavité 72.

Il est entendu que, dans la mesure où les parois 72b de la cavité 72 sont recouvertes de la couche de protection 80, la croissance, et notamment l'orientation cristalline, du premier matériau 20a est déterminée par la nature et l'orientation cristalline du substrat support 40 au niveau du fond 72a.

La couche de protection 80 (sous forme de matériau amorphe) limite l'apparition de défauts cristallins lors de l'étape de croissance épitaxiale du premier matériau.

Selon une première alternative, l'étape de croissance sélective peut comprendre une séquence comprenant les étapes consistant à :
d1) faire croître de manière épitaxiale une couche faite du premier matériau 20a en recouvrement du fond 72a et des parois 72b de la cavité 72 ;
d2) graver sélectivement la couche faite du premier matériau 20a déposée sur les parois 72b de la cavité 72 (figure 3E et 4C).

La séquence comprenant les étapes d1) et d2) peut alors être répétée autant de fois que nécessaire pour que la cavité 72 soit remplie avec le premier matériau 20a monocristallin.

Selon cette première alternative, le rapport d'aspect de la cavité 72 est avantageusement supérieur à un quart.

Par « rapport d'aspect », on entend le rapport d'une dimension caractéristique de l'ouverture de la cavité sur la profondeur de cette dernière. La largeur, selon la présente invention, se mesure d'une paroi à l'autre de la cavité selon un axe orthogonal à la direction d'empilement En particulier, cette dimension caractéristique peut être le côté d'un carré, la longueur d'un rectangle ou encore le diamètre d'un cercle. L'invention n'est toutefois pas limitée à ces seules formes, et l'homme du métier, compte tenu de la définition qui en est donnée, pourra déterminer la dimension caractéristique à d'autres formes.

Selon une seconde alternative, l'étape d) de croissance comprend une étape de croissance épitaxiale permettant de faire croître le premier matériau 20a de manière monocristalline à partir du fond 72a de la cavité 72, et de manière polycristalline ou défectueuse à partir de la couche de protection 80.

L'étape de croissance est par ailleurs exécutée en présence d'un agent chimique permettant de graver sélectivement le premier matériau sous forme polycristalline au regard de sa forme monocristalline.

À titre d'exemple, la formation d'une première région 20 faite de silicium monocristallin peut faire intervenir un précurseur du type silane (SiH₄) ou dichlorosilane (SiH₂Cl₂) en présence d'un agent chimique qui comprend du chlorure d'hydrogène (HCl).

Cette seconde alternative permet de considérer des rapports d'aspect pour la cavité 72 inférieurs à un quart.

Quel que soit l'alternative considérée, la première région 20 et la deuxième région 30 présentent chacune une surface exposée à l'environnement extérieur en affleurement l'une de l'autre.

Le procédé selon la présente invention peut également comprendre une étape e) de formation d'une tranchée 90 d'isolation remplie d'un matériau diélectrique 91 destinée isoler électriquement l'au moins une première région 20 de l'au moins une deuxième région 30.

L'étape e) comprend en particulier la formation d'une tranchée 90 autour ou le long de la première région 20.

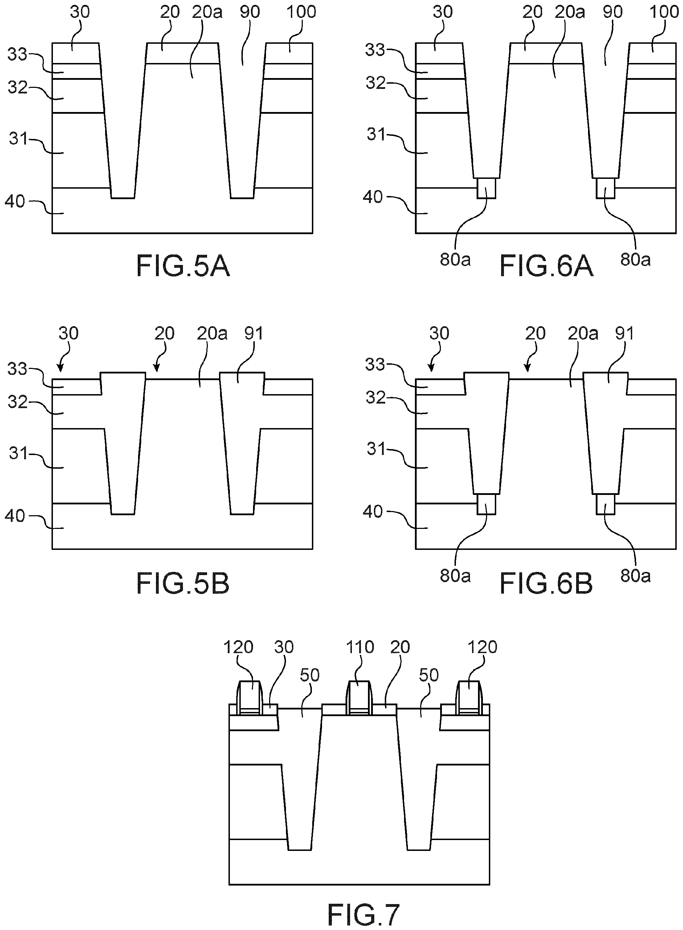

Notamment, les figures 5A et 6A illustrent la formation de la tranchée 90 dans le cadre, respectivement, de la première variante et de la seconde variante.

La formation de la tranchée 90 peut comprendre les étapes suivantes :
e1) formation d'un masque dur 100 de dioxyde de silicium et/ou de nitrure de silicium ;
e2) la gravure sèche et anisotrope.

La seconde variante (figure 6A) laisse apparaître un reliquat 80a de la couche de protection 80 à l'issue de l'étape e).

La tranchée 90 est ensuite remplie d'un matériau diélectrique 91, par exemple du dioxyde de silicium.

Les figures 5B et 6B illustrent, à cet égard, le remplissage de la tranchée 90 dans le cadre, respectivement, de la première variante et de la seconde variante.

Le remplissage peut en particulier comprendre un dépôt conforme dudit matériau diélectrique 91 suivi d'une étape de polissage mécano chimique (« CMP » ou « Chemical Mechanical Polishing » selon la terminologie Anglo-Saxonne) de manière à conserver le matériau diélectrique dans la tranchée uniquement.

Le masque dur peut être également retiré selon une étape de gravure sélective.

Enfin, le procédé selon la présente invention peut également comprendre une étape de formation de dispositifs microélectroniques 110 et 120, respectivement, sur les premières et deuxièmes régions (figure 7).

Le substrat mixte obtenu à l'issue de l'étape d) est dépourvu de composant microélectronique, et notamment de transistor.

## Revendications

1. Procédé de fabrication d'un substrat mixte (10) qui comprend, sur une face principale (40a) d'un substrat support (40), une première région (20), comprenant un premier matériau (20a) monocristallin, et une seconde région (30), contiguë à la première région (20), comprenant un deuxième matériau (30a), le procédé comprend les étapes suivantes :
a) fournir un substrat de départ (60) qui comprend un empilement (15) comprenant au moins une couche intermédiaire (31) en recouvrement de la face principale (40a) du substrat support (40), la couche intermédiaire comprenant le deuxième matériau (30a) sous forme monocristalline ou polycristalline ;
b) former un masque (70) sur l'empilement (15), ledit masque (70) comprenant une ouverture (71) délimitant l'emplacement de la première région (20) ;
c) graver la structure (15) au niveau de l'ouverture (71) de manière à former une cavité (72) délimitée par un fond (72a) et des parois (72b), le fond (72a) étant situé sur ou dans le substrat support (40) ;
d) former la première région (20) par croissance épitaxiale du premier matériau (20a) sous forme monocristalline dans la cavité (72),
le procédé étant **caractérisé en ce qu'**il comprend une étape c1), exécutée avant l'étape d), de formation d'une couche de protection (80), faite d'un matériau amorphe, recouvrant ou recouvrant exclusivement les parois (72b) de la cavité (72), de sorte à laisser exposée à l'environnement extérieur le fond (72a) de ladite cavité (72), dans lequel, à l'issue de l'étape d), le premier matériau (20a) rempli intégralement la cavité (72).

2. Procédé selon la revendication 1, l'étape d) comprend également une gravure du premier matériau (20a) susceptible d'être formé sous forme polycristalline sur les parois (72b) délimitant la cavité (72).

3. Procédé selon la revendication 1 ou 2, dans lequel l'étape c1) comprend la formation d'une couche de matériau (80a) en recouvrement du fond (72a) et des parois (72b) des cavités (72), et le retrait de ladite couche (80a) au niveau du fond (72a) des cavités (72), avantageusement le retrait de la couche de matériau (80a) comprend une gravure sèche anisotrope.

4. Procédé selon l'une des revendications 1 à 3, dans lequel la couche de protection (80) comprend au moins des matériaux choisi parmi : dioxyde de silicium, du nitrure de silicium, SiCO, SiBCN.

5. Procédé selon l'une des revendications 1 à 4, dans lequel l'étape d) comprend au moins une séquence comprenant les étapes :
d1) faire croître de manière épitaxiale une couche faite du premier matériau (20a) en recouvrement du fond (72a) et des parois (72b) de la cavité (72) ;
d2) graver sélectivement la couche faite du premier matériau (20a) déposée sur les parois (72b) de la cavité (72),
la séquence étant répétée autant de fois que nécessaire pour que la cavité (72) soit remplie avec le premier matériau (20a) monocristallin, avantageusement la cavité (72) présente un rapport d'aspect supérieur à un quart.

6. Procédé selon l'une des revendications 1 à 4, dans lequel l'étape d) comprend une étape de croissance épitaxiale permettant de faire croître le premier matériau (20a) de manière monocristalline à partir du fond (72a) de la cavité (72), et de manière polycristalline sur la couche de protection (80), l'étape de croissance étant exécutée en présence d'un agent chimique permettant de graver sélectivement le premier matériau (20a) sous forme polycristalline au regard de sa forme monocristalline.

7. Procédé selon la revendication 6, dans lequel l'étape d) met en oeuvre un précurseur comprenant du SiH₄ ou du dichlorosilane, et un agent chimique comprenant du HCl.

8. Procédé selon la revendication 6 ou 7, dans lequel la cavité (72) présente un rapport d'aspect inférieur à un quart.

9. Procédé selon l'une des revendications 1 à 8, dans lequel la première région (20) et la deuxième région (30) présentent chacune une surface exposée à l'environnement extérieur en affleurement l'une de l'autre.

10. Procédé selon l'une des revendications 1 à 9, dans lequel l'empilement (15) comprend en outre une couche utile (33) et une couche diélectrique (32), la couche diélectrique (32) étant disposée entre ladite couche utile (33) et la couche intermédiaire (31), la couche utile (33) et la couche diélectrique (32) étant également gravées au niveau de l'ouverture (71) lors de l'exécution de l'étape c), avantageusement, la couche utile (33) comprend du silicium, la couche diélectrique (32) comprend du dioxyde de silicium, et la couche intermédiaire (31) comprend du silicium polycristallin.

11. Procédé selon l'une des revendications 1 à 10, dans lequel l'étape b) comprend la formation d'un masque (70) dur, le masque (70) dur comprenant notamment un matériau diélectrique.

12. Procédé selon l'une des revendications 1 à 11, dans lequel l'étape c) comprend une gravure sèche, notamment une gravure plasma.

13. Procédé selon l'une des revendications 1 à 12, dans lequel le procédé comprend en outre une étape e), exécutée après l'étape d), de formation d'une tranchée d'isolation (90) remplie d'un matériau diélectrique destinée à isoler électriquement la première région (20) de la deuxième région (30), avantageusement, la tranchée (90) d'isolation s'étend jusque dans le substrat support (40) ou s'arrête dans la couche intermédiaire (31).

14. Procédé selon l'une des revendications 1 à 13, dans lequel le premier matériau (20a) comprend au moins l'un des matériaux choisi parmi : Si, SiGe.

15. Procédé selon l'une des revendications 1 à 14, dans lequel le substrat mixte obtenu à l'issue de l'étape d) est dépourvu de composant microélectronique, et notamment de transistor.

## Patentansprüche

1. Verfahren zum Herstellen eines gemischten Substrats (10), das auf einer Hauptfläche (40a) eines Trägersubstrats (40) einen ersten Bereich (20), der ein erstes einkristallines Material (20a) umfasst, und einen zweiten Bereich (30) umfasst, der an den ersten Bereich (20) angrenzt und ein zweites Material (30a) umfasst, wobei das Verfahren die folgenden Schritte umfasst:
a) Bereitstellen eines Ausgangssubstrats (60), das einen Stapel (15) umfasst, der mindestens eine Zwischenschicht (31) umfasst, die die Hauptfläche (40a) des Trägersubstrats (40) überlappt, wobei die Zwischenschicht das zweite Material (30a) in einer einkristallinen oder polykristallinen Form umfasst;
b) Bilden einer Maske (70) auf dem Stapel (15), wobei die Maske (70) eine Öffnung (71) umfasst, die die Stelle des ersten Bereichs (20) begrenzt;
c) Ätzen der Struktur (15) an der Öffnung (71), um einen durch einen Boden (72a) und Wände (72b) begrenzten Hohlraum (72) zu bilden, wobei sich der Boden (72a) auf oder im Trägersubstrat (40) befindet;
d) Bilden des ersten Bereichs (20) durch epitaktisches Wachstum des ersten Materials (20a) in einkristalliner Form in dem Hohlraum (72),
wobei das Verfahren **dadurch gekennzeichnet ist, dass** es einen vor Schritt d) ausgeführten Schritt c1) des Bildens einer Schutzschicht (80) aus einem amorphen Material umfasst, die die Wände (72b) des Hohlraums (72) überlappt oder ausschließlich überlappt, so dass der Boden (72a) des Hohlraums (72) der äußeren Umgebung exponiert bleibt, wobei nach Abschluss von Schritt d) das erste Material (20a) den Hohlraum (72) vollständig ausfüllt.

2. Verfahren nach Anspruch 1, wobei Schritt d) auch ein Ätzen des ersten Materials (20a) umfasst, das geeignet ist, in polykristalliner Form auf den den Hohlraum (72) begrenzenden Wänden (72b) gebildet zu werden.

3. Verfahren nach Anspruch 1 oder 2, wobei Schritt c1) das Bilden einer Materialschicht (80a), die den Boden (72a) und die Wände (72b) der Hohlräume (72) überlappt, und das Entfernen der Schicht (80a) am Boden (72a) der Hohlräume (72) umfasst, wobei das Entfernen der Materialschicht (80a) vorteilhafterweise ein anisotropes Trockenätzen umfasst.

4. Verfahren nach einem der Ansprüche 1 bis 3, wobei die Schutzschicht (80) mindestens eines der Materialien umfasst, die aus Folgendem ausgewählt sind: Siliziumdioxid, Siliziumnitrid, SiCO und SiBCN.

5. Verfahren nach einem der Ansprüche 1 bis 4, wobei Schritt d) mindestens eine Sequenz umfasst, die die folgenden Schritte umfasst:
d1) epitaktisches Aufwachsen einer Schicht aus dem ersten Material (20a), die den Boden (72a) und die Wände (72b) des Hohlraums (72) überlappt;
d2) selektives Ätzen der Schicht aus dem ersten Material (20a), die auf den Wänden (72b) des Hohlraums (72) abgeschieden wird,
wobei der Ablauf so oft wie nötig wiederholt wird, bis der Hohlraum (72) mit dem ersten einkristallinen Material (20a) gefüllt ist, wobei der Hohlraum (72) vorzugsweise ein Seitenverhältnis von mehr als einem Viertel aufweist.

6. Verfahren nach einem der Ansprüche 1 bis 4, wobei Schritt d) einen Schritt des epitaktischen Wachstums umfasst, der das Aufwachsen des ersten Materials (20a) in einkristalliner Weise vom Boden (72a) des Hohlraums (72) und in polykristalliner Weise auf der Schutzschicht (80) ermöglicht, wobei der Wachstumsschritt in Gegenwart eines chemischen Mittels ausgeführt wird, das das selektive Ätzen des ersten Materials (20a) in polykristalliner Form gegenüber seiner einkristallinen Form ermöglicht.

7. Verfahren nach Anspruch 6, wobei Schritt d) einen Vorläufer, der SiH₄ oder Dichlorsilan umfasst, und ein chemisches Mittel, das HCl umfasst, umfasst.

8. Verfahren nach Anspruch 6 oder 7, wobei der Hohlraum (72) ein Seitenverhältnis von weniger als einem Viertel aufweist.

9. Verfahren nach einem der Ansprüche 1 bis 8, wobei der erste Bereich (20) und der zweite Bereich (30) jeweils eine einer äußeren Umgebung exponierte Oberfläche aufweisen, die bündig miteinander abschließen.

10. Verfahren nach einem der Ansprüche 1 bis 9, wobei der Stapel (15) ferner eine Nutzschicht (33) und eine dielektrische Schicht (32) umfasst, wobei die dielektrische Schicht (32) zwischen der Nutzschicht (33) und der Zwischenschicht (31) angeordnet ist, wobei die Nutzschicht (33) und die dielektrische Schicht (32) während des Ausführens von Schritt c) auch an der Öffnung (71) geätzt werden, wobei die Nutzschicht (33) vorzugsweise Silizium umfasst, die dielektrische Schicht (32) Siliziumdioxid umfasst und die Zwischenschicht (31) polykristallines Silizium umfasst.

11. Verfahren nach einem der Ansprüche 1 bis 10, wobei Schritt b) das Bilden einer Hartmaske (70) umfasst, wobei die Hartmaske (70) insbesondere ein dielektrisches Material umfasst.

12. Verfahren nach einem der Ansprüche 1 bis 11, wobei Schritt c) ein Trockenätzen, insbesondere ein Plasmaätzen, umfasst.

13. Verfahren nach einem der Ansprüche 1 bis 12, wobei das Verfahren ferner einen nach Schritt d) ausgeführten Schritt e) des Bildens eines Isolationsgrabens (90) umfasst, der mit einem dielektrischen Material gefüllt und dazu bestimmt ist, den ersten Bereich (20) elektrisch vom zweiten Bereich (30) zu isolieren, wobei sich der Isolationsgraben (90) vorzugsweise bis zum Trägersubstrat (40) erstreckt oder in der Zwischenschicht (31) endet.

14. Verfahren nach einem der Ansprüche 1 bis 13, wobei das erste Material (20a) mindestens eines der Materialien umfasst, die aus Folgendem ausgewählt sind: Si, SiGe.

15. Verfahren nach einem der Ansprüche 1 bis 14, wobei das nach Abschluss von Schritt d) erhaltene gemischte Substrat keine mikroelektronischen Komponenten, insbesondere Transistoren, aufweist.

## Claims

1. A method for manufacturing a mixed substrate (10) which comprises, on a main face (40a) of a support substrate (40), a first region (20), comprising a first single crystal material (20a), and a second region (30), contiguous to the first region (20), comprising a second material (30a), the method comprises the following steps of:
a) providing a starting substrate (60) which comprises a stack (15) comprising at least one intermediate layer (31) overlaying the main face (40a) of the support substrate (40), the intermediate layer comprising the second material (30a) in a single crystal or polycrystalline form;
b) forming a mask (70) on the stack (15), said mask (70) comprising an aperture (71) delimiting the location of the first region (20);
c) etching the structure (15) at the aperture (71) so as to form a cavity (72) delimited by a bottom (72a) and walls (72b), the bottom (72a) being located on or in the support substrate (40);
d) forming the first region (20) by epitaxially growing the first material (20a) in a single crystal form in the cavity (72),
the method being **characterised in that** it comprises a step c1), performed before step d), of forming a protective layer (80), made of an amorphous material, covering or exclusively covering the walls (72b) of the cavity (72) so as to leave the bottom (72a) of said cavity (72) exposed to external environment, wherein, at the end of step d), the first material (20a) entirely fills the cavity (72).

2. The method according to claim 1, wherein step d) further comprises etching the first material (20a) likely to be formed in a polycrystalline form on the walls (72b) delimiting the cavity (72).

3. The method according to claim 1 or 2, wherein step c1) comprises forming a layer (80a) of material overlaying the bottom (72a) and walls (72b) of the cavities (72), and removing said layer (80a) at the bottom (72a) of the cavities (72), advantageously removing the layer (80a) of material comprises anisotropic dry etching.

4. The method according to one of claims 1 to 3, wherein the protective layer (80) comprises at least one of the materials selected from: silicon dioxide, silicon nitride, SiCO, SiBCN.

5. The method according to one of claims 1 to 4, wherein step d) comprises at least one sequence comprising the steps of:
d1) epitaxially growing a layer made of the first material (20a) overlaying the bottom (72a) and walls (72b) of the cavity (72);
d2) selectively etching the layer made of the first material (20a) deposited on the walls (72b) of the cavity (72),
the sequence being repeated as many times as necessary for the cavity (72) to be filled with the first single crystal material (20a), advantageously the cavity (72) has an aspect ratio greater than one quarter.

6. The method according to one of claims 1 to 4, wherein step d) comprises an epitaxial growth step for growing the first material (20a) in a single crystal way from the bottom (72a) of the cavity (72), and in a polycrystalline way on the protective layer (80), the growth step being performed in the presence of a chemical agent for selectively etching the first material (20a) in a polycrystalline form in view of its single crystal form.

7. The method according to claim 6, wherein step d) implements a precursor comprising SiH₄ or dichlorosilane, and a chemical agent comprising HCl.

8. The method according to claim 6 or 7, wherein the cavity (72) has an aspect ratio lower than one quarter.

9. The method according to one of claims 1 to 8, wherein the first region (20) and second region (30) each have a surface exposed to external environment flush with each other.

10. The method according to one of claims 1 to 9, wherein the stack (15) further comprises a useful layer (33) and a dielectric layer (32), the dielectric layer (32) being disposed between said useful layer (33) and the intermediate layer (31), the useful layer (33) and dielectric layer (32) being also etched at the aperture (71) when performing step c), advantageously, the useful layer (33) comprises silicon, the dielectric layer (32) comprises silicon dioxide, and the intermediate layer (31) comprises polycrystalline silicon.

11. The method according to one of claims 1 to 10, wherein step b) comprises forming a hard mask (70), the hard mask (70) especially comprising a dielectric material.

12. The method according to one of claims 1 to 11, wherein step c) comprises dry etching, especially plasma etching.

13. The method according to one of claims 1 to 12, wherein the method further comprises a step e), performed after step d), of forming a trench isolation (90) filled with a dielectric material for electrically insulating the first region (20) from the second region (30), advantageously, the trench isolation (90) extends into the support substrate (40) or stops in the intermediate layer (31).

14. The method according to one of claims 1 to 13, wherein the first material (20a) comprises at least one of the materials selected from: Si, SiGe.

15. The method according to one of claims 1 to 14, wherein the mixed substrate obtained at the end of step d) is free of microelectronic component, and especially of transistor.
